**Europäisches Patentamt**

**European Patent Office**

**Office européen des brevets**

(11) Veröffentlichungsnummer: **0 337 193**

**A1**

# (12) EUROPÄISCHE PATENTANMELDUNG

(21) Anmeldenummer: **89105564.2**

(22) Anmeldetag: **29.03.89**

(51) Int. Cl.4: **H03K 17/73 , H03K 17/08 , H02H 7/20**

(30) Priorität: **11.04.88 DE 3812019**

(43) Veröffentlichungstag der Anmeldung:
**18.10.89 Patentblatt 89/42**

(84) Benannte Vertragsstaaten:
**CH DE FR GB IT LI SE**

(71) Anmelder: **Siemens Aktiengesellschaft**
**Wittelsbacherplatz 2**
**D-8000 München 2(DE)**

(72) Erfinder: **Baudelot, Eric, Dr.**
**Spinnereistrasse 14**
**D-8520 Erlangen(DE)**

(54) **Schutzschaltung für einen Abschaltthyristor.**

(57) Um einen abgeschalteten GTO beim Ausfall der negativen Gate/Kathoden-Spannung zu schützen, ist zwischen Gate und Kathode ein niederohmiger Parallelpfad vorgesehen, der aus einer Reihenschaltung einer Schottky-Diode (SD) und eines Vorschaltwiderstandes ($R_F$) gebildet ist.

FIG 7

EP 0 337 193 A1

## Schutzschaltung für einen Abschaltthyristor

Die Erfindung betrifft eine schutzschaltung für einen Abschaltthyristor, bei dem zwischen dem Steueranschluß ("Gate") und Kathode eine Reihenschaltung aus einem Widerstand und einer Diode geschaltet ist.

Ein derartiger Abschaltthyristor ist aus der GB-A-2 030 796 bekannt. Die Diode dient in einem Fernseher dazu, die Horizontalablenkung zu steuern, wobei bei einer rückwärts leitenden GTO-Schaltung die in Richtung von der GTO-Kathode zum Steuereingang gepolte Diode eine zum GTO-Thyristor antiparallele Hochspannungsdiode ersetzt. Die gleiche Polung weist auch eine Reihenschaltung aus Diode und Widerstand in der DE-A-2 202 749 auf, die als Sperrschaltung für Störsignale vorgeschlagen wird.

Ein Abschaltthyristor ("gate turn of"-Thyristor, GTO) ist im abgeschalteten Zustand beim Ausfall der zwischen Gate und Kathode liegenden negativen Steuerspannung gefährdet. Es ist daher bekannt, für den "Sperrstrom", der im abgeschalteten Zustand aus dem Gate-Anschluß in die Kathode fließt, einen niederohmigen Parallelpfad vorzusehen.

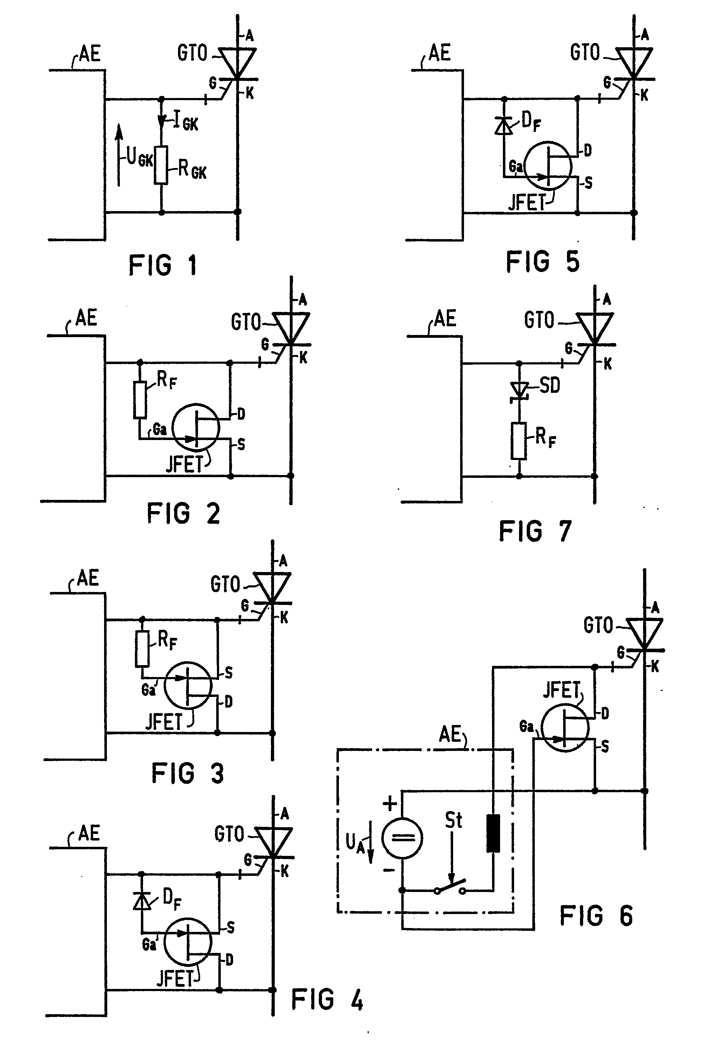

In Fig. 1 ist eine derartige bekannte Schaltung gezeigt, bei der parallel zur Gate-Kathoden-Strecke zwischen die Ansteueranschlüsse der GTO-Ansteuerschaltung A ein Widerstand $R_{GK}$ geschaltet ist. Die Ansteuerschaltung A muß in diesem Fall bei Normalbetrieb sowohl im eingeschalteten Zustand, wie auch im ausgeschalteten Zustand eine erhebliche Verlustleistung aufbringen, die über den niederohmigen Widerstand $R_{GK}$ver braucht wird.

Die im eingeschalteten Zustand entstehenden Verluste können vermieden werden, wenn der Widerstand durch einen Feldeffekttransistor ersetzt wird, der von der Ansteuereinheit AE je weils mit dem entsprechenden Abschaltsignal des GTO eingeschaltet wird. Die Figuren 2 und 3 zeigen eine derartige Anordnung, wobei der Sperrschicht-Feldeffekttransistor "JFET" die niederohmige Verbindung zwischen Gate und Kathode des GTO's darstellt und der Steueranschluß GA des JFET über einen Vorschaltwiderstand $R_F$ mit dem Gate-Anschluß G des GTO verbunden ist. Um aber diesen Parallelpfad zwischen Gate und Kathode des GTO ausreichend niederohmig zu halten, sind in der Regel mehrere JFET parallel zu schalten. Dadurch verringern sich zwar die Verluste im abgeschalteten Zustand, jedoch wird der apparative Aufwand erhöht. Entsprechend den Figuren 4 und 5 kann anstelle eines Vorschaltthyristors $R_f$ auch eine Vorschalt-Diode $D_F$ verwendet werden.

In Fig. 6 ist das Prinzip der Ansteuereinheit AE dargestellt, bei der eine negative Sperrspannung beim Auftreten eines Abschaltsignals St über einen elektronischen Schalter an den Steueranschluß G des GTO's gelegt wird. In diesem Fall ist der Steueranschluß GA des JFET an den entsprechenden Anschluß der negativen Spannungsquelle $U_A$ der Ansteuereinheit AE angeschlossen.

Eine weitere Variante, die Verluste im Normalbetrieb vermeidet und eine Reihenschaltung aus einem JFET oder einem MOSFET mit einer Schottky-Diode verwendet, ist in der nichtvorveröffentlichten europäischen Anmeldung EP-A-256 426 dargestellt.

Der Erfindung liegt die Aufgabe zugrunde, eine Schutzschaltung für einen GTO anzugeben, die sowohl einen geringen apparativen Aufwand wie eine geringe Verlustleistung erfordert, um den GTO bei einem Ausfall der negativen Gate-Kathoden-Spannung zu schützen.

Diese Aufgabe wird dadurch gelöst, daß bei einem GTO, dem eine Reihenschaltung aus einem Widerstand und einer Diode zwischen seinem Steueranschluß und seinem Kathodenanschluß geschaltet ist, erfindungsgemäß der Widerstand niederohmig und die Diode eine vom Steueranschluß zum Kathodenanschluß gepolte Schottkydiode ist.

Diese Schaltung ist in Fig. 7 dargestellt. Der in Reihe zur Schottky-Diode SD geschaltete Widerstand $R_F$ wird vorteilhaft so gewählt, daß der Spannungsabfall in dieser Schaltung beim maximalen Anodensperrstrom kleiner als eine vorgegebene Grenze, die z.B. vorteilhaft bei 0,6 V liegt, bleibt. Die Schottky-Diode bewirkt, daß im normalen Abschaltzustand keine Verluste auftreten. Da im eingeschalteten Zustand jedoch nur eine geringe Spannung, z.B. 1 V, am Gate wirksam ist, ist auch der Verlustanteil im eingeschalteten Zustand relativ klein.

## Ansprüche

Schutzschaltung für einen Abschaltthyristor (GTO) mit einer Reihenschaltung aus einem Widerstand und einer Diode zwischen dem Steueranschluß (G) und dem Kathodenanschluß (K), **dadurch gekennzeichnet,** daß der Widerstand ($R_F$) niederohmig und die Diode eine vom Steueranschluß (G) zum Kathodenanschluß (K) gepolte Schottky-Diode (SD) ist.

EP 0 337 193 A1

88 P 3138

FIG 1

FIG 2

FIG 3

FIG 4

FIG 5

FIG 7

FIG 6

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A,D | GB-A-2 030 796 (TOKYO SHIBAURA) <br> * Figur 5; Ansprüche 1,4 * <br> --- | 1 | H 03 K 17/73 <br> H 03 K 17/08 <br> H 02 H 7/20 |
| A,D | DE-A-2 202 749 (HONEYWELL) <br> * Figur 2; Seite 5, Zeilen 8-17 * <br> ----- | 1 | |

RECHERCHIERTE SACHGEBIETE (Int. Cl.4)

H 03 K
H 02 H
H 02 M

**Der vorliegende Recherchenbericht wurde für alle Patentansprüche erstellt**

| Recherchenort | Abschlußdatum der Recherche | Prüfer |
|---|---|---|
| DEN HAAG | 28-06-1989 | KOLBE W.H. |